# EUROPEAN PATENT SPECIFICATION

(11) **EP 4 488 701 B1**
(45) Date of publication and mention of the grant of the patent: **28.01.2026**
(21) Application number: 24162810.6
(22) Date of filing: 12.03.2024
(51) Int. Cl.: G01R 31/392

(54) **BATTERY LIFE ESTIMATION METHOD AND BATTERY SYSTEM**
VERFAHREN ZUR SCHÄTZUNG DER BATTERIELEBENSDAUER UND BATTERIESYSTEM
PROCÉDÉ D'ESTIMATION DE DURÉE DE VIE DE BATTERIE ET SYSTÈME DE BATTERIE

(30) Priority: 04.07.2023 KR 20230086671
(43) Date of publication of application: 08.01.2025
(73) Proprietor: Samsung SDI Co., Ltd., Yongin-si, Gyeonggi-do 17084 (KR)
(72) Inventor: Ahn, Taesung, Yongin-si, Gyeonggi-do 17084 (KR); Lee, Changhyun, Yongin-si, Gyeonggi-do 17084 (KR); Lee, Sunmin, Yongin-si, Gyeonggi-do 17084 (KR); Kim, Jake, Yongin-si, Gyeonggi-do 17084 (KR); Ahn, Gijang, Yongin-si, Gyeonggi-do 17084 (KR)
(74) Representative: Gulde & Partner

(56) References cited:
- EP-A1- 3 379 278
- EP-A1- 4 198 537
- US-A1- 2021 349 157

## Description

### BACKGROUND

### 1. Field

Aspects of embodiments of the present disclosure relate to a battery life estimation method and a battery system.

### 2. Description of the Related Art

A battery life estimation model configures various combinations of various factors affecting battery deterioration, and based on such data, an expected life value for a battery use profile may be obtained. EP 4 198 537 A1, EP 3 379 278 A1 and US 2021/349157 A1 disclose examples of methods and systems for such a battery life estimation.

However, life deterioration of a battery is not determined only by physical conditions at a corresponding time, but has a hysteresis property. For example, reaction mechanisms inside a battery operating at room temperature for the first 6 months of a 1-year cycle and at a low temperature of 10 degrees for the following 6 months thereafter may be different from reaction mechanisms inside a battery operating at a low temperature for the first 6 months of a 1-year cycle and at room temperature for the following 6 months thereafter. As such, information about the time sequence of operating the battery may be an important (e.g., very important) consideration.

The above information disclosed in this Background section is for enhancement of understanding of the background of the present disclosure, and therefore, it may contain information that does not constitute prior art.

### SUMMARY

The present invention is set out in the appended set of claims, wherein the drawings and respective description relate to advantageous embodiments thereof.

Typically, because it may be difficult for a BMS system of a vehicle or energy storage system (ESS) to store the factors that affect the life deterioration in time order due to limited memory capacity, data may be stored in a format of counting events over time for respective factors.

However, because the data stored in the event count format may not include information over time and may be data that simply counts physical quantities, it may not be accurate to estimate the battery life using only such corresponding information.

It was an object of the present invention to provide a battery system which allows to estimate a life of a battery module with improved accuracy. It was also an object of the present invention to provide a method to detect a warranty risk in advance.

The present invention is directed to a battery system and a battery life estimation method that may more accurately estimate a battery life. According to the present invention, in the event that a life issue occurs in the future, it is possible to evaluate the usage history of a user's battery and thus establish a criterion for determining whether there is a problem with the battery or abnormal usage outside the warranty range.

According to one or more embodiments of the present disclosure, a battery system includes: a battery; a detection device configured to detect a voltage, a current, and a temperature from the battery; and a battery management system (BMS) configured to: estimate a state of charge (SOC) based on the voltage, the current, and the temperature detected from the detection device; store a profile generated by measuring a physical state of the battery in an event count format based on battery state data including the voltage, the current, and the temperature and the SOC; generate a virtual scenario for driving a representative battery based on the profile; and estimate a life of the battery through the virtual scenario.

In an embodiment, the BMS may include: a scenario generator configured to generate a scenario of M days, M being a natural number greater than or equal to 1; a scenario corrector configured to generate N scenarios of M days based on the scenario of M days, N being a natural number greater than or equal to 2; and a life estimator configured to estimate the life of the battery by simulating a battery operation based on the N scenarios of M days.

In an embodiment, the scenario generator may be configured to generate a scenario template of the M days based on a probability of occurrence of each of a plurality of stored representative templates; and each of the plurality of stored representative templates may include a value representing a charging and discharging ratio in a unit of a day of the battery as a probability.

In an embodiment, based on each time point at which a charging state of the representative battery is switched from among the scenario templates of M days, the scenario generator may be configured to randomly sample physical quantities at each time point from the profile to generate a specific scenario of M days.

In an embodiment, the profile may include: a charging log table generated based on data obtained if the battery is in a charging state from among the battery state data; a discharging log table generated based on data obtained if the battery is in a discharging state; and a rest log table generated based on data obtained if the battery is in a rest state.

In an embodiment, the scenario generator may be configured to: derive a physical quantity at a start time point of a charging period of the scenario templates of M days from the charging log table; derive a physical quantity at a start time point of a discharging period of the scenario templates of M days from the discharging log table; and derive a physical quantity at a start time point of a rest period of the scenario templates of M days from the rest log table.

In an embodiment, the scenario corrector may be configured to restore N number of the scenarios of M days to generate the N scenarios of M days by utilizing a Monte-Carlo simulation method.

In an embodiment, the life estimator may be configured to: simulate the N scenarios of M days multiple times; determine one from among simulation results of the multiple simulations as a life estimation model for the battery; and estimate the life of the battery using the life estimation model.

According to one or more embodiments of the present disclosure, a life estimation method includes: detecting a voltage, a current, and a temperature from a battery; estimating a state of charge (SOC) based on the voltage, the current, and the temperature detected from the battery; generating and storing a profile by measuring a physical state of the battery in an event count format based on battery state data including the voltage, the current, and the temperature and the SOC; generating a virtual scenario for driving a representative battery based on the profile; and estimating a life of the battery through the virtual scenario.

In an embodiment, the estimating of the life of the battery may include: generating a scenario of M days, M being a natural number greater than or equal to 1; generating N scenarios of M days based on the scenario of M days, N being a natural number greater than or equal to 2; and estimating the life of the battery by simulating a battery operation based on the N scenarios of M days.

In an embodiment, the generating of the scenario of M days may include generating a scenario template of the M days based on a probability of occurrence of each of a plurality of stored representative templates, and each of the plurality of stored representative templates may include a value representing a charging and discharging ratio in a unit of a day of the battery as a probability.

In an embodiment, the generating of the scenario of M days may include, based on each time point at which a charging state of the representative battery is switched from among the scenario templates of M days, randomly sampling physical quantities at each time point from the profile to generate a specific scenario of M days.

In an embodiment, the generating and storing of the profile may include: generating a charging log table based on data obtained if the battery is in a charging state from among the battery state data; generating a discharging log table based on data obtained if the battery is in a discharging state; and generating a rest log table based on data obtained if the battery is in a rest state.

In an embodiment, the generating of the specific scenario of M days may include: deriving a physical quantity at a start time point of a charging period of the scenario templates of M days from the charging log table; deriving a physical quantity at a start time point of a discharging period of the scenario templates of M days from the discharging log table; and deriving a physical quantity at a start time point of a rest period of the scenario templates of M days from the rest log table.

In an embodiment, the generating of the N scenarios of M days may include restoring N number of the scenarios of M days to generate the N scenarios of M days by utilizing a Monte-Carlo simulation method.

In an embodiment, the estimating of the life of the battery by simulating the battery operation may include: simulating the N scenarios of M days multiple times; determining one from among simulation results of the multiple simulations as a life estimation model of the battery; and estimating the life of the battery using the life estimation model.

According to one or more embodiments of the present disclosure, it may be possible to estimate a life of a battery module with improved accuracy (e.g., high accuracy) using smaller capacity (e.g., a small-capacity) memory.

According to one or more embodiments of the present disclosure, it may be possible to detect warranty risk in advance through accurate life estimation of a battery.

According to one or more embodiments of the present disclosure, if a life issue occurs in the future, usage history of a user's battery may be estimated, and thus, it may be possible to prepare a criterion for determining whether there is a problem with the battery or abnormal use outside the warranty range.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 illustrates a block diagram of a battery system according to an embodiment.
FIG. 2 illustrates an example of a rest log table according to an embodiment.
FIG. 3 illustrates a block diagram of a configuration of an MCU of FIG. 1.
FIG. 4 illustrates a flowchart of a battery life estimation method according to an embodiment.
FIG. 5 illustrates an example of a representative scenario pattern template according to an embodiment.
FIG. 6 illustrates an example of a scenario template of M days according to an embodiment.
FIG. 7 illustrates an example of an operation of generating a scenario of M days according to an embodiment.
FIG. 8 illustrates an example of a best case scenario from among various scenarios according to an embodiment.
FIG. 9 illustrates an example of a worst case scenario from among various scenarios according to an embodiment.
FIG. 10 illustrates a graph of simulation results obtained by simulating a reconstructed scenario 3000 times according to an embodiment.
FIG. 11 illustrates a graph of average data of the simulation results shown in FIG. 10.
FIG. 12 illustrates a graph comparing the average data shown in FIG. 11 with a value estimated by an actual life model of a battery.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

As used herein, the terms "module," "unit," "portion," or "part" representing constituent element used in the following description are used only in order to make understanding of the specification easier, and thus, these terms do not have meanings or roles that distinguish them from each other by themselves. A program implemented as a set of instructions embodying a control algorithm used for controlling another component may be installed in a component for controlling another component under a specific control condition from among components according to an embodiment. A control component may generate output data by processing input data and stored data according to the installed program. The control component may include a non-volatile memory for storing a program and a memory for storing data.

Moreover, the electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

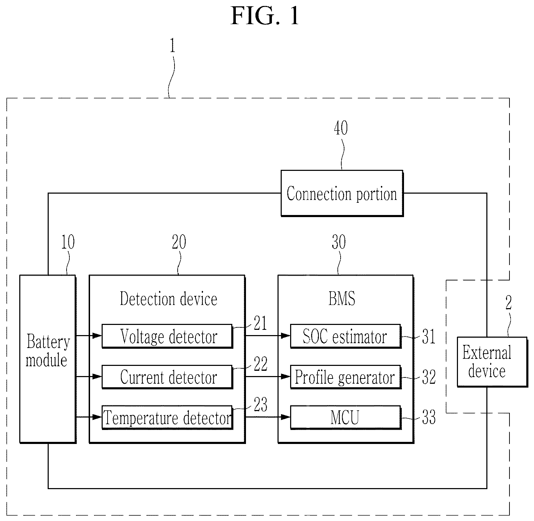

FIG. 1 illustrates a block diagram of a battery system according to an embodiment.

Referring to FIG. 1, a battery system 1 may include a battery module (e.g., a battery) 10, a detection device 20, a battery management system (BMS) 30, and a connection portion 40.

The connection portion 40 may be implemented as a relay or the like, and may be connected in series between the battery module 10 and an external device 2. The connection portion 40 may operate by a signal supplied from the BMS 30.

The battery system 1 may be connected to the external device 2. The external device 2 may include a load, such as an inverter and a converter, and/or a charging device. For example, the battery system 1 may be connected to a charger, and may be supplied with power from the charger to be charged. As another example, the battery system 1 may be connected to a load, and power supplied by the battery module 10 may be discharged through the load.

The battery module 10 may include a plurality of battery cells connected in series and/or in parallel.

The detection device 20 may detect a state of the cells configuring the battery module 10 based on a signal received from the battery module 10. The signal received by the detection device 20 from the battery module 10 may include a voltage measurement signal representing a voltage across each of the cells configuring the battery module 10, a current measurement signal representing a current flowing through the battery module 10, and a temperature measurement signal representing a temperature.

The detection device 20 may include a voltage detector 21, a current detector 22, and a temperature detector 23.

The voltage detector 21 may detect a cell voltage of each of the cells configuring the battery module 10, a module voltage of the battery module 10, and/or the like. The current detector 22 may detect a current flowing through the battery module 10. The temperature detector 23 may detect a temperature from at least one point of the battery module 10.

Hereinafter, voltage information, current information, and temperature information generated by the detection device 20 may be referred to as detection data. The detection data may be generated if an event (e.g., a preset event) occurs. For example, the preset event may include a time arrival according to a cycle (e.g., a predetermined cycle), a switching to a charging state, a discharging state, or a rest state of a battery, a charging start and end of a battery, and/or an elapse of a time (e.g., a predetermined time) after starting battery charging. Hereinafter, for convenience, it is assumed that the detection data is collected if an event in which the detection device 20 is switched to each of the charging state, the discharging state, and the rest state of the battery module 10 occurs.

The BMS 30 may receive the detection data of the battery module 10 from the detection device 20. The BMS 30 may monitor a voltage, a current, a temperature, a state of charge (SOC), a charge rate (C-rate), and/or the like (hereinafter, referred to as "battery states") of the battery module 10 based on the detected data. The BMS 30 may generate a battery charging/discharging profile based on a battery state monitoring result, and may estimate a life of the battery module 10 based on the battery charging/discharging profile.

The BMS 30 may include an SOC estimator 31, a profile generator 32, and a main control unit (MCU) (e.g., a main controller) 33.

The SOC estimator 31 may estimate the SOC of the battery module 10 using one of a current integration method that integrates charging/discharging currents, an electrochemical model method that represents a chemical reaction inside the cell in molecular units, a mathematical method that represents an operating time of a battery and a dynamic behavior of a state of charge (SOC) in a purely mathematical experimental manner, and/or a voltage modeling method using a relationship between an open circuit voltage (OCV) and a state of charge (SOC).

The SOC estimator 31 may transmit the value estimated as the SOC of the battery module 10 (hereinafter, referred to as the "SOC of the battery module 10") to the profile generator 32 and the MCU 33.

Hereinafter, the battery status data may indicate the battery states monitored by the BMS 30, such as the detection data obtained by the profile generator 32 from the detection device 20 and the SOC, and the C-rate of the battery module 10 obtained from the SOC estimator 31.

The profile generator 32 may generate and store a profile (hereinafter referred to as the "profile") representing physical values of factors related to the life of the battery module 10 based on the battery state data. Here, the profile is a time series profile representing changes in various factors over time, such as an SOC, a C-rate, and a temperature, and may be classified according to the state of charge of the battery. The charging state of the battery may be one of the charging state, the discharging state, and/or the rest state. Here, the discharging state may include a state in which a vehicle is driving (Driving), and the rest state may include a state in which a vehicle is parked (Parking).

The profile generator 32 may indicate the physical state of the battery module 10, and may store a profile generated by measuring events of factors related to the life of the battery module 10 in an event count format. The event count format may represent a method of measuring a physical quantity (e.g., event) to be stored at regular time intervals in a corresponding storage. Hereinafter, a profile generated by measuring factors related to the life of the battery module 10 in an event count format by the profile generator 32 is referred to as field data.

The battery state data indicates values of factors over time, such as an SOC, a temperature, and a C-rate, and because the field data is generated and stored in the event count format, it may represent the values of factors (the SOC, the temperature, and the C-rate) other than the physical quantity of time.

The field data may be represented by a three-dimensional matrix representing physical quantities of SOC, temperature, and C-rate. For example, the field data may be a log table representing events related to the life of the battery module 10 for each state of charge of the battery in a matrix representing three physical quantities of SOC, temperature, and C-rate.

The profile generator 32 may implement field data generated based on the battery state data obtained while the battery module 10 is in a charged state as a charging log table. The profile generator 32 may implement field data generated based on the battery state data obtained while the battery module 10 is in a discharged state as a discharging log table. The profile generator 32 may implement field data generated based on the battery state data obtained while the battery module 10 is in a rest state as a rest log table.

Hereinafter, for convenience, it is assumed that the field data generated by the profile generator 32 is at least one of the charging log table, the discharging log table, and/or the rest log table.

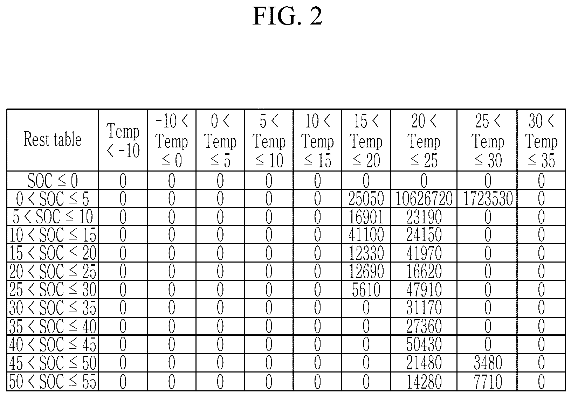

FIG. 2 illustrates an example of a rest log table according to an embodiment.

Referring to FIG. 2, the profile generator 32 may generate a log table by counting events for the SOC and temperature values if the battery module 10 is in a rest state. In the example of FIG. 2, most of the events were recorded if the SOC was greater than 0 and less than 5 and the temperature is greater than 20 degrees and less than 25 degrees.

However, the present disclosure is not limited thereto, and the charging log table, the discharging log table, and the rest log table may be stored in the BMS 30.

Hereinafter, for convenience, it is assumed that the profile generator 32 generates and stores the charging, discharging, and rest log tables.

The MCU 33 may generate a scenario template for driving the battery module 10 based on the battery state data. The MCU 33 may generate a virtual scenario (hereinafter referred to as a "scenario") for driving the battery based on the scenario template and the field data generated by the profile generator 32, and may estimate the life of the battery module 10 by simulating a battery operation based on the generated scenario.

According to one embodiment the BMS 30 may comprise an SOC estimator 31, a profile generator 32 and a main control unit MCU 33, and the MCU 33 may comprise a scenario generator 331 configured to generate a scenario of M days, M being a natural number greater than or equal to 1; a scenario corrector 332 configured to generate N scenarios of M days based on the scenario of M days, N being a natural number greater than or equal to 2; and a life estimator 333 configured to estimate the life of the battery by simulating a battery operation based on the N scenarios of M days.

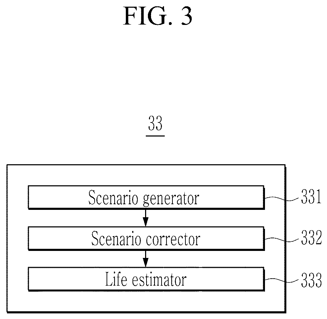

FIG. 3 illustrates a block diagram of a configuration of the MCU of FIG. 1.

Referring to FIG. 3, the MCU 33 may include a scenario generator 331, a scenario corrector 332, and a life estimator 333.

Based on the battery state data, the scenario generator 331 may generate an M-day scenario that drives the battery module 10 for M days (where M is a natural number of 1 or more).

The scenario corrector 332 may correct the M-day scenarios generated by the scenario generator 331 to generate N (where N is a natural number equal to or greater than 2) M-day scenarios to improve the scenario accuracy.

The life estimator 333 may simulate driving of the battery based on the corrected scenario, and may estimate the life of the battery module 10 through the simulation.

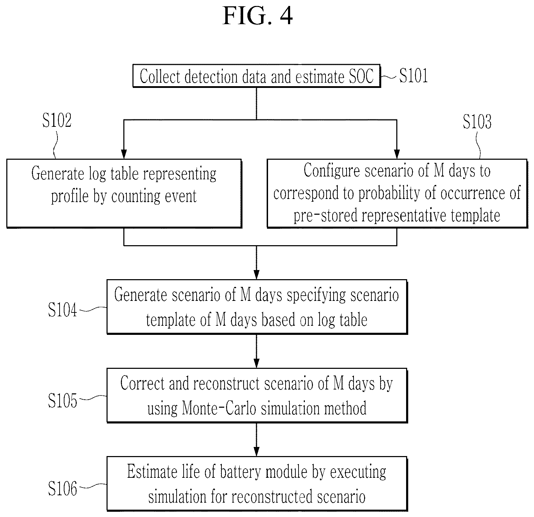

Hereinafter, an operation of the MCU 33 will be described in more detail with reference to FIG. 4.

FIG. 4 illustrates a flowchart of a battery life estimation method according to an embodiment.

Hereinafter, redundant description with respect to the battery system 1 described above may not be repeated.

Referring to FIG. 4, the detection device 20 may collect detection data based on signals received from the battery module 10 for a suitable period (e.g., a predetermined period), and the SOC estimator 31 may estimate the SOC of the battery module 10 based on the detection data (S101). Thus, in (S101) of the method according to one embodiment, a voltage, a current, and a temperature from a battery may be detected and the SOC, based on the voltage, the current, and the temperature detected from the battery may be estimated.

The profile generator 32 may generate a log table representing a profile by counting events representing physical values of factors related to the life of the battery module 10 based on the battery state data (S102). In (S102) of the method according to one embodiment, a log table representing a profile by counting events may be generated.

The BMS 30 may previously store a probability of occurrence of each of a plurality of representative templates represented by the battery state data.

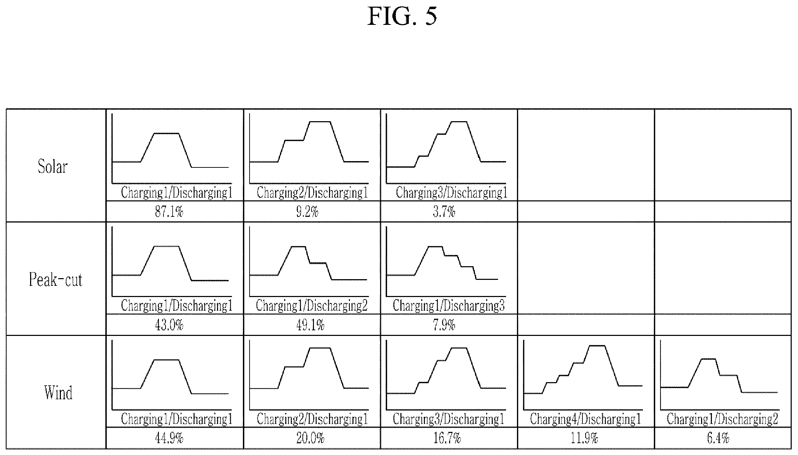

Hereinafter, the probability of occurrence of each of the plurality of representative templates will be described in more detail with reference to FIG. 5.

FIG. 5 illustrates an example of a representative scenario template according to an embodiment.

A plurality of templates may represent a pattern of a scenario. Here, the pattern of the scenario may be represented by a shape of a graph that appears regularly if the actual use pattern of the battery module 10 is schematized with the ratio of charging, discharging, and rest per day and with the SOC value over time. The plurality of templates may be generated in daily units according to the actual use of the battery module 10.

From among the plurality of templates, a plurality of representative templates representing actual use patterns of the battery module 10 may be stored (e.g., pre-stored) in the BMS 30. The plurality of representative templates may be templates having a probability of occurrence greater than or equal to a level (e.g., a predetermined level) from among the plurality of templates, or a number (e.g., a predetermined number) of template(s) from among the plurality of templates.

Referring to FIG. 5, if the battery module 10 is an energy storage system (ESS), the representative templates are classified into solar, peak-cut, wind, and the like according to the application of energy stored in the ESS. Each representative template may include a value representing the daily charging and discharging (or charging, discharging, and rest) rate for each classified application as a probability, and a daily graph according to the daily charging and discharging (or charging, discharging, and rest) rate. For example, the BMS 30 may receive the probability of the daily charging and discharging ratio analyzed from the information of the solar application already in use as Charging1/Discharging1 - 87.1 %, Charging2/Discharging1 - 9.2 %, and Charging3/Discharging1 - 3.7 %.

In the example of Figure 5, the solar application may include: a first representative template including 1 charging, 1 rest, and 1 discharging per day; a second representative template including 2 charging, 2 rest, and 1 discharging per day; and a third representative template including 3 charging, 3 rest, and 1 discharging per day.

In addition, the peak-cut application may include: a fourth representative template including 1 charging, 1 rest, and 1 discharging per day; a fifth representative template including 1 charging, 2 rest, and 2 discharging per day; and a sixth representative template including 1 charging, 3 rest, and 3 discharging per day.

In addition, the wind application may include: a seventh representative template including 1 charging, 1 rest, and 1 discharging per day; an eighth representative template including 2 charging, 2 rest, and 1 discharging per day; a ninth representative template including 3 charging, 3 rest, and 1 discharging per day; a tenth representative template including 4 charging, 4 rest, and 1 discharging per day; and an eleventh representative template including 1 charging, 2 rest, and 2 discharging per day.

In the solar application, the occurrence probability of the first representative template including 1 charging, 1 rest, and 1 discharging per day was found to be 87.1 % of the actual use patterns of the entire solar application. In addition, the occurrence probability of the second representative template including 2 charging, 2 rest, and 1 discharging per day was found to be 9.2 % of the actual use patterns of the entire solar application. In addition, the occurrence probability of the third representative template including 3 charging, 3 rest, and 1 discharging per day was found to be 3.7 % of the actual use patterns of the entire solar application.

In the peak-cut application, the occurrence probability of the fourth representative template including 1 charging, 1 rest, and 1 discharging per day was found to be 43.0 % of the actual use patterns of the entire peak-cut application. In addition, the occurrence probability of the fifth representative template including 1 charging, 2 rest, and 2 discharging per day was found to be 49.1 % of the actual use patterns of the entire peak-cut application. In addition, the occurrence probability of the sixth representative template including 1 charging, 3 rest, and 3 discharging per day was found to be 7.9 % of the actual use patterns of the entire peak-cut application.

In the wind application, the occurrence probability of the seventh representative template including 1 charging, 1 rest, and 1 discharging per day was found to be 44.9 % of the actual use patterns of the entire wind application. In addition, the occurrence probability of the eighth representative template including 2 charging, 2 rest, and 1 discharging per day was found to be 20.0 % of the actual use patterns of the entire wind application. In addition, the occurrence probability of the ninth representative template including 3 charging, 3 rest, and 1 discharging per day was found to be 16.7 % of the actual use patterns of the entire wind application. In addition, the occurrence probability of the tenth representative template including 4 charging, 4 rest, and 1 discharging per day was found to be 11.9 % of the actual use patterns of the entire wind application. In addition, the occurrence probability of the eleventh representative template including 1 charging, 2 rest, and 2 discharging per day was found to be 6.4 % of the actual use patterns of the entire wind application.

Referring back to FIG. 4, the scenario generator 331 may configure (e.g., may generate) scenario templates of M days based on the probability of occurrence of each of the pre-stored plurality of representative templates (S103). According to a preferred embodiment the scenario generator 331 may be configured to generate a scenario template of the M days based on a probability of occurrence of each of a plurality of stored representative templates and each of the plurality of stored representative templates may comprise a value representing a charging and discharging ratio in a unit of a day of the battery as a probability.

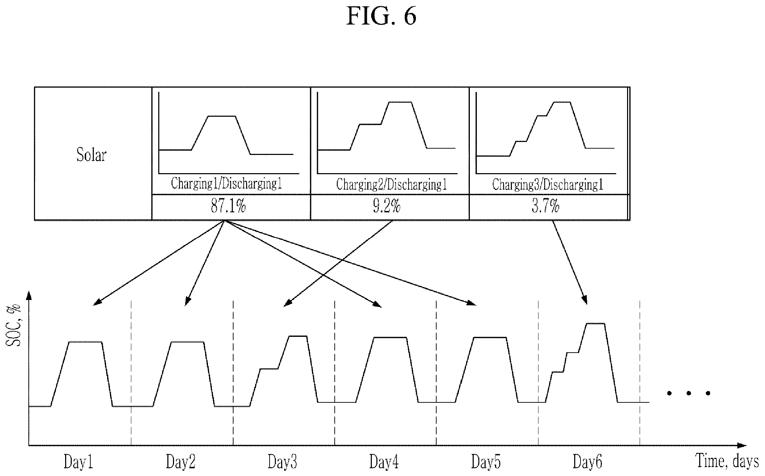

Hereinafter, the configuring of the scenario templates (S103) will be described in more detail with reference to FIG. 6.
FIG. 6 illustrates an example of a scenario template of M days according to an embodiment. In (S103) of the method according to one embodiment, a scenario of M days may be configured to correspond to the probability of occurrence of pre-stored representative template.

The scenario generator 331 may generate a scenario template for a period (e.g., a predetermined period) to reconstruct a scenario for the period using a representative template. Here, the period (e.g., the predetermined period) may be previously determined as initial information. Hereinafter, the period is assumed to be M days.

The scenario generator 331 may construct M-day scenario templates by connecting M representative templates according to the probability of occurrence of the representative templates.

In the example of FIG. 6, the solar application is illustrated. In the solar application, the scenario generator may generate a scenario template for M days including 87.1 % of the first representative template including 1 charging and 1 discharging per day, 9.2 % of the second representative template including 2 charging and 1 discharging per day, and 3.7 % of the third representative template including 3 charging and 1 discharging per day.

Referring to FIG. 6, for example, a 100-day scenario template corresponding to the solar application generated by the scenario generator 331 may include 87 first representative templates including 1 charging and 1 discharging per day, 9 second representative templates including 2 charging and 1 discharging per day, and 4 third representative templates including 3 charging and 1 discharging per day.

Referring back to FIG. 4, the scenario generator 331 may generate a scenario of M days embodying a scenario template of M days based on the log table (S104). In (S104) of the method according to one embodiment, a scenario of M days specifying the scenario template of M days based on a log table may be generated.

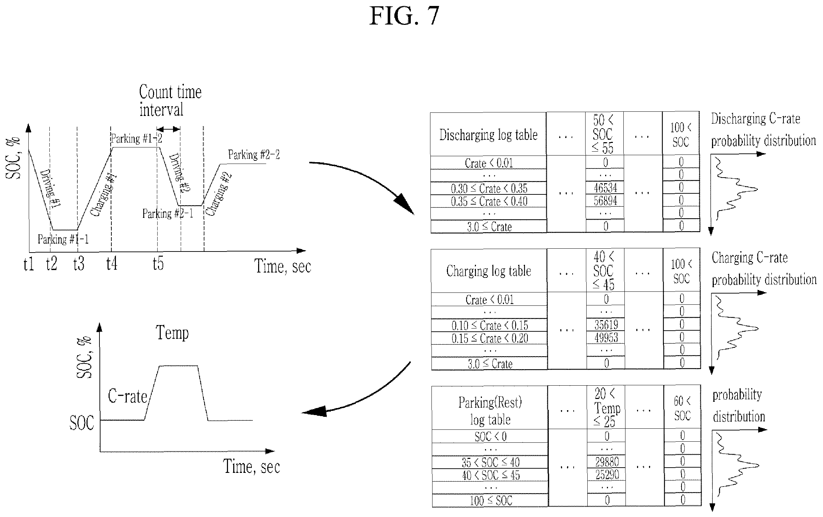

Hereinafter, the generating of the scenario of M days (e.g., S104) will be described in more detail with reference to FIG. 7.

FIG. 7 illustrates an example of an operation of generating a scenario of M days according to an embodiment.

The scenario template of M days may include a plurality of periods in which the battery module 10 is charged (hereinafter, referred to as "charging periods"), a plurality of periods in which the battery module 10 is discharged (hereinafter, referred to as "discharge periods"), and a plurality of periods in which the battery module 10 is in a rest state (hereinafter, referred to as "rest periods"). The scenario generator 331 may realize the template by performing random number-based random sampling according to a probability distribution of required physics at each time point at which the state of charge of the battery is switched from among the scenario templates of M days. Each time point at which the battery charge state is switched may indicate a start time point of each of a plurality of charging intervals, a plurality of discharging intervals, and a plurality of rest intervals included in the scenario template of M days.

The scenario generator 331 may derive physical quantities required at each time point at which the state of charge of the battery is switched, or in other words, values such as C-rate, SOC, and temperature, from one of the charging log table, the discharging log table, and/or the rest log table through random sampling. According to one embodiment, based on each time point at which a charging state of the representative battery may be switched from among the scenario templates of M days, the scenario generator 331 may be configured to randomly sample physical quantities at each time point from the profile to generate a specific scenario of M days.

For example, if the scenario generator 331 derives values such as C-rate, SOC, and temperature from one of the charging log table, the discharging log table, and/or the rest log table, a value to be derived may be determined based on the number of events represented by each log table. In the example of FIG. 7, the scenario generator 331 may derive one C-rate value and one SOC value in a period in which the C-rate representing the highest event number (e.g., 56894) in the discharging log table is 0.35 or more and less than 0.40 and the SOC is more than 50 and 55 or less.

In the example of FIG. 7, the scenario template of M days may include a discharging period (Driving #1), a rest period (Parking #1-1), a charging period (Charging #1), a rest period (Parking #1-2), and a discharging period (Driving #2), a rest period (Parking #2-1), a charging period (Charging #2), a rest period (Parking #2-2), and the like.

Referring to FIG. 7, a time point at which the discharging period (Driving #1) starts is referred to as t1, a time point at which the rest period (Parking #1-1) starts is referred to as t2, a time point at which the charging period (Charging #1) starts is referred to as t3, and a time point at which the rest period (Parking #1-2) starts is referred to as t4.

Because the time point t1 is the start time point of the discharging period (Driving #1), the scenario generator 331 may derive the C-rate value and the SOC value from the discharging log table. For example, the scenario generator 331 may derive one C-rate value in a range of 0.35 or more and less than 0.40 from the discharging log table, and may derive one SOC value in a range of greater than 50 and 55 or less.

The scenario generator 331 may realize a scenario by using one C-rate value and one SOC value derived from the discharging log table. For example, the scenario generator 331 may set the SOC value derived from the discharging log table as the SOC value at the time point t1, and may set the C-rate value derived from the discharging log table as the slope value of the SOC graph from the time point t1 to the time point t2.

Because the time point t2 is the start time point of the rest period (Parking #1-1), the scenario generator 331 may derive the SOC value and the temperature value from the rest log table. For example, the scenario generator 331 may derive one SOC value in a range of greater than 35 and less than 40, and may derive one temperature in a range of greater than 20 degrees and less than 25 degrees, from the rest log table.

The scenario generator 331 may realize a scenario by using one SOC value and one temperature value derived from the rest log table. For example, the scenario generator 331 may set the SOC value derived from the rest log table as the SOC value at the time point t2, and may set the temperature value derived from the rest log table as the temperature value from the time point t2 to the time point t3.

Because the time point t3 is the start time point of the charging period (Charging #1), the scenario generator 331 may derive the C-rate value and the SOC value from the charging log table. For example, the scenario generator 331 may derive one C-rate value in a range of 0.15 or more and less than 0.20 from the charging log table, and may derive one SOC value in a range of greater than 40 and 45 or less.

The scenario generator 331 may realize a scenario by using one C-rate value and one SOC value derived from the charging log table. For example, the scenario generator 331 may set the SOC value derived from the charging log table as the SOC value at the time point t3, and may set the C-rate value derived from the charging log table as an absolute value of the slope of the SOC graph from the time point t3 to the time point t4.

Because the time point t4 is the start time point of the rest period (Parking #1-2), the scenario generator 331 may derive the SOC value and the temperature value from the rest log table. For example, the scenario generator 331 may derive one SOC value in a range of greater than 35 and less than 40, and may derive one temperature in a range of greater than 20 degrees and less than 25 degrees, from the rest log table.

The scenario generator 331 may realize a scenario by using one SOC value and one temperature value derived from the rest log table. For example, the scenario generator 331 may set the SOC value derived from the rest log table as the SOC value at the time point t4, and may set the temperature value derived from the rest log table as the temperature value from the time point t4 to the time point t5.

As described above, the scenario generator 331 may generate a detailed scenario of M days by random-sampling the physical values corresponding to the start time points of each of the plurality of charging periods, the plurality of discharging periods, and the plurality of rest periods included in the scenario template of M days based on the charging log table, the discharging log table, and the rest log table.

Referring back to FIG. 4, the scenario corrector 332 may correct and reconstruct the scenario of M days (S105). In (S105) of the method according to one embodiment, a scenario of M days may be corrected and reconstructed by using the Monte-Carlo simulation method.

Field data generated by the profile generator 32 may not include a physical quantity representing time in the process of analyzing a profile and analyzing an event related to the life of the battery module 10. The scenario corrector 332 and the life estimator 333 may use a Monte-Carlo simulation method so as to supplement the time information lost in the field data, so that the scenario of M days may cover various cases.

The scenario corrector 332 may restore N (where N is a natural number of 2 or more) scenarios of the scenarios of M days. N may be a sufficient number to cover various cases through the scenarios. According to a preferred embodiment, the scenario corrector 332 may be configured to restore N number of the scenarios of M days to generate the N scenarios of M days by utilizing a Monte-Carlo simulation method.

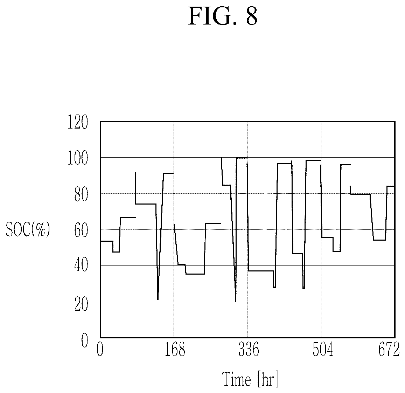

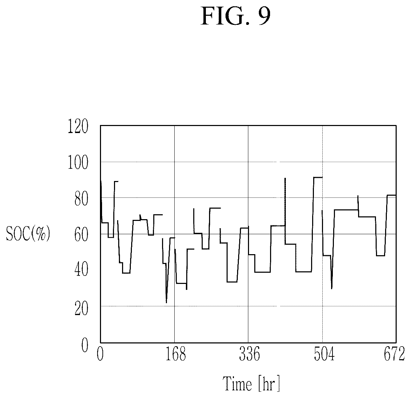

Hereinafter, a best case scenario and a worst case scenario from among N scenarios of M days generated by the scenario corrector 332 will be described in more detail with reference to FIG. 8 and FIG. 9.

FIG. 8 illustrates an example of a best case scenario from among various scenarios according to an embodiment.

Referring to FIG. 8, the best case scenario from among the N scenarios of M days restored by the scenario corrector 332 may be a case in which a low depth of discharge (DOD), a low C-rate, and an optimal temperature are combined with each other. Here, the DOD may be estimated from an SOC.

FIG. 9 illustrates an example of a worst case scenario from among various scenarios according to an embodiment.

Referring to FIG. 9, the worst case scenario from among N scenarios of M days restored by the scenario corrector 332 may be a case in which a high DOD, a high C-rate, and the worst temperature are combined with each other.

Referring to FIG. 8 and FIG. 9, the scenarios of M days generated by the scenario generator 331 and N scenarios of M days restored by the scenario corrector 332 are constructed by extracting physical quantities from the field data, so there is no continuity of SOC unlike the original pattern of SOC over time.

The scenario corrector 332 may generate N scenarios of M days including the best case scenario and the worst case scenario, and may reconstruct the scenario including the N scenarios of M days. Hereinafter, for convenience, the generated and reconstructed N scenarios of M days by the scenario corrector 332 is referred to as a "reconstructed scenario."

Referring back to FIG. 4, the life estimator 333 may estimate the life of the battery module 10 by executing a simulation (hereinafter, the "simulation") to estimate the battery life for the reconstructed scenario (S106). In (S106) of the method according to one embodiment, the life of a battery module may be estimated by executing simulation for a reconstructed scenario.

According to a preferred embodiment, the estimating of the life of the battery by simulating the battery operation may comprise simulating the N scenarios of M days multiple times; determining one from among simulation results of the multiple simulations as a life estimation model of the battery; and estimating the life of the battery using the life estimation model.

The simulation may virtually perform charging and discharging of the battery according to the SOC value indicated by the scenario, and may estimate the SOH of the battery. The SOH of the battery may indicate the life and degree of deterioration of the corresponding battery.

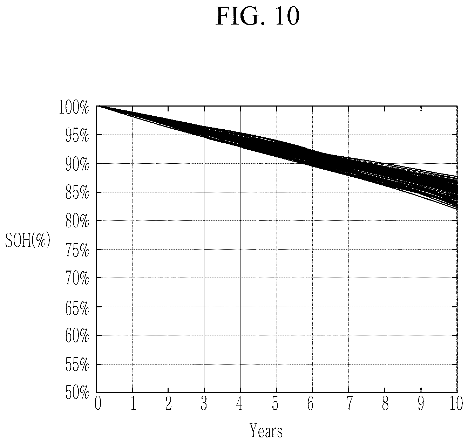

Hereinafter, an operation of the life estimator 333 for correcting a scenario through simulation will be described in more detail with reference to FIG. 10 through FIG. 12.

FIG. 10 illustrates a graph of simulation results obtained by simulating a reconstructed scenario 3000 times according to an embodiment.

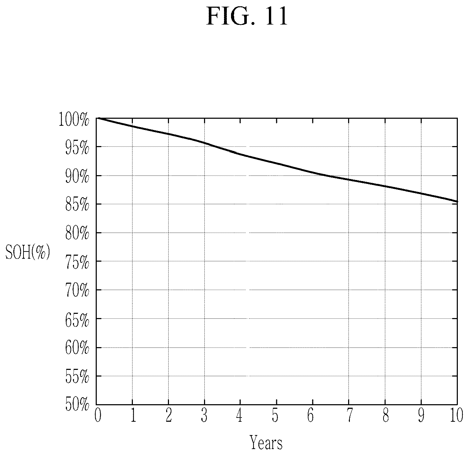

FIG. 11 illustrates a graph of average data of the simulation results shown in FIG. 10.

Referring to FIG. 10, the life estimator 333 may proceed multiple times with respect to the reconstructed scenario. In the examples of FIG. 10 and FIG. 11, it is shown that the life estimator 333 has performed 3000 simulations.

Referring to FIG. 11, the life estimator 333 may represent average data from among the simulation results of simulating the reconstructed scenario multiple times in a graph.

In FIG. 11, N scenarios of M days are simulated 3,000 times, and the average data of the simulation results is a representative value of the 3,000 simulations, but the present disclosure is not limited thereto.

The life estimator 333 may determine the life estimation model of the battery module 10 by using one data that best represents the scenario from among the results of multiple simulations for N scenarios of M days as a representative value of the simulation.

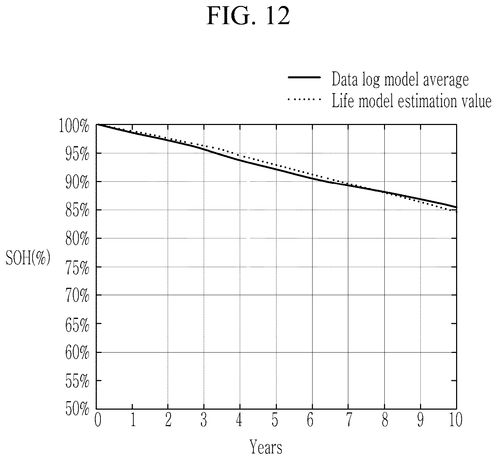

FIG. 12 illustrates a graph comparing the average data shown in FIG. 11 with a value estimated by an actual life model of a battery.

Referring to FIG. 12, the average data (e.g., data log model average) according to the embodiment shown in FIG. 11 is displayed as a solid line, and the estimated value (e.g., life model estimated value) of the actual life model of a comparative battery is displayed as a dotted line. By comparing the solid line and the dotted line shown in FIG. 12, the accuracy of the scenario reconstructed according to one or more embodiments may be confirmed.

Based on the average data according to the embodiment shown in FIG. 11, the average SOH error based on 10 years and the maximum value of the error based on 10 years of the estimated value of the actual life model of the battery may be calculated.

In addition, according to the experimental data in FIG. 12, based on the average data according to the embodiment shown in FIG. 11, it was found that the error of the SOH value at 10 years from the estimated value of the actual life model of the battery was 0.85 %p, the average error value for 10 years was 0.45 %p, and the maximum value of the 10-year standard error was 0.9 %p.

As a result of comparison, the maximum value of the 10-year standard error at each time point is within 1 %p, and the error of the 10-year standard SOH, which is often used if determining the life of the battery, is also 0.85 %p, and thus, the suitability and reliability of the life estimation method according to one or more embodiments may be secured.

The life estimator 333 may estimate the life of the battery module 10 by using the life estimation model of the battery module 10 that best represents the scenario from among the results of the multiple simulations for the reconstructed scenario.

### Description of symbols

1: battery system
10: battery module
20: detection device
21: voltage detector
22: current detector
23: temperature detector
30: battery management system (BMS)
31: SOC estimator
32: profile generator
33: main control unit (MCU)
331: scenario generator
332: scenario corrector
333: life estimator
40: connection portion
2: external device

## Claims

1. A battery system comprising:
a battery;
a detection device (20) configured to detect a voltage, a current, and a temperature from the battery; and
a battery management system (BMS, (30)) configured to:
estimate a state of charge (SOC) based on the voltage, the current, and the temperature detected from the detection device (20);
**characterized in that** the battery management system (BMS, (30)) is further configured to;
store a profile generated by measuring a physical state of the battery in an event count format based on battery state data including the voltage, the current, and the temperature and the SOC;
generate a virtual scenario for driving a representative battery based on the profile; and
estimate a life of the battery through the virtual scenario.

2. The battery system as claimed in claim 1, wherein the BMS (30) comprises:
a scenario generator (331) configured to generate a scenario of M days, M being a natural number greater than or equal to 1;
a scenario corrector (332) configured to generate N scenarios of M days based on the scenario of M days, N being a natural number greater than or equal to 2; and
a life estimator (333) configured to estimate the life of the battery by simulating a battery operation based on the N scenarios of M days.

3. The battery system as claimed in claim 2, wherein:
the scenario generator (331) is configured to generate a scenario template of the M days based on a probability of occurrence of each of a plurality of stored representative templates; and
each of the plurality of stored representative templates comprises a value representing a charging and discharging ratio in a unit of a day of the battery as a probability.

4. The battery system as claimed in claims 2 or 3, wherein, based on each time point at which a charging state of the representative battery is switched from among the scenario templates of M days, the scenario generator (331) is configured to randomly sample physical quantities at each time point from the profile to generate a specific scenario of M days.

5. The battery system as claimed in any of claims 1 to 4, wherein the profile comprises:
a charging log table generated based on data obtained if the battery is in a charging state from among the battery state data;
a discharging log table generated based on data obtained if the battery is in a discharging state; and
a rest log table generated based on data obtained if the battery is in a rest state.

6. The battery system as claimed in any of claims 2 to 5, wherein the scenario generator (331) is configured to:
derive a physical quantity at a start time point of a charging period of the scenario templates of M days from the charging log table;
derive a physical quantity at a start time point of a discharging period of the scenario templates of M days from the discharging log table; and
derive a physical quantity at a start time point of a rest period of the scenario templates of M days from the rest log table.

7. The battery system as claimed in any of claims 2 to 6, wherein the scenario corrector (332) is configured to restore N number of the scenarios of M days to generate the N scenarios of M days by utilizing a Monte-Carlo simulation method.

8. The battery system as claimed in any of claims 2 to 7, wherein the life estimator (333) is configured to:
simulate the N scenarios of M days multiple times;
determine one from among simulation results of the multiple simulations as a life estimation model for the battery; and
estimate the life of the battery using the life estimation model.

9. A life estimation method comprising:
detecting a voltage, a current, and a temperature from a battery;
estimating a state of charge (SOC) based on the voltage, the current, and the temperature detected from the battery;
**characterized in that** the method further comprises the steps of:
generating and storing a profile by measuring a physical state of the battery in an event count format based on battery state data including the voltage, the current, and the temperature and the SOC;
generating a virtual scenario for driving a representative battery based on the profile; and
estimating a life of the battery through the virtual scenario.

10. The life estimation method as claimed in claim 9, wherein the estimating of the life of the battery comprises:
generating a scenario of M days, M being a natural number greater than or equal to 1;
generating N scenarios of M days based on the scenario of M days, N being a natural number greater than or equal to 2; and
estimating the life of the battery by simulating a battery operation based on the N scenarios of M days.

11. The life estimation method as claimed in claim 10, wherein the generating of the scenario of M days comprises generating a scenario template of the M days based on a probability of occurrence of each of a plurality of stored representative templates, and
wherein each of the plurality of stored representative templates comprises a value representing a charging and discharging ratio in a unit of a day of the battery as a probability.

12. The life estimation method as claimed in claims 10 or 11, wherein the generating of the scenario of M days comprises, based on each time point at which a charging state of the representative battery is switched from among the scenario templates of M days, randomly sampling physical quantities at each time point from the profile to generate a specific scenario of M days.

13. The life estimation method as claimed in any of claims 9 to 12, wherein the generating and storing of the profile comprises:
generating a charging log table based on data obtained if the battery is in a charging state from among the battery state data;
generating a discharging log table based on data obtained if the battery is in a discharging state; and
generating a rest log table based on data obtained if the battery is in a rest state.

14. The life estimation method as claimed in claims 12 or 13, wherein the generating of the specific scenario of M days comprises:
deriving a physical quantity at a start time point of a charging period of the scenario templates of M days from the charging log table;
deriving a physical quantity at a start time point of a discharging period of the scenario templates of M days from the discharging log table; and
deriving a physical quantity at a start time point of a rest period of the scenario templates of M days from the rest log table.

15. The life estimation method as claimed in any of claims 10 to 14, wherein the generating of the N scenarios of M days comprises restoring N number of the scenarios of M days to generate the N scenarios of M days by utilizing a Monte-Carlo simulation method.

## Patentansprüche

1. Batteriesystem, umfassend:
eine Batterie;
eine Erfassungsvorrichtung (20), die dazu konfiguriert ist, eine Spannung, einen Strom und eine Temperatur aus der Batterie zu erfassen; und
ein Batteriemanagementsystem (BMS, (30)), das dazu konfiguriert ist, einen Ladezustand (SOC) auf der Grundlage der Spannung, des Stroms und der Temperatur, die von der Erfassungsvorrichtung (20) erfasst werden, zu schätzen;
**dadurch gekennzeichnet, dass** das Batteriemanagementsystem (BMS, (30)) ferner dazu konfiguriert ist,
ein Profil, das durch Messen eines physikalischen Zustands der Batterie erzeugt wird, in einem Ereigniszählformat auf der Grundlage von Batteriezustandsdaten, die die Spannung, den Strom, die Temperatur und den SOC enthalten, zu speichern;
ein virtuelles Szenario zum Antreiben einer repräsentativen Batterie auf der Grundlage des Profils zu erzeugen; und
eine Lebensdauer der Batterie durch das virtuelle Szenario zu schätzen.

2. Batteriesystem nach Anspruch 1, wobei das BMS (30) Folgendes umfasst:
einen Szenario-Generator (331), der dazu konfiguriert ist, ein Szenario von M Tagen zu erzeugen, wobei M eine natürliche Zahl größer oder gleich 1 ist;
einen Szenario-Korrektor (332), der dazu konfiguriert ist, N Szenarien von M Tagen auf der Grundlage des Szenarios von M Tagen zu erzeugen, wobei N eine natürliche Zahl größer oder gleich 2 ist; und
einen Lebensdauer-Schätzer (333), der dazu konfiguriert ist, die Lebensdauer der Batterie durch Simulieren eines Batteriebetriebs auf der Grundlage der N Szenarien von M Tagen zu schätzen.

3. Batteriesystem nach Anspruch 2, wobei:
der Szenario-Generator (331) dazu konfiguriert ist, eine Szenario-Vorlage der M Tage auf der Grundlage einer Auftrittswahrscheinlichkeit jeder von mehreren gespeicherten repräsentativen Vorlagen zu erzeugen; und
jede der mehreren gespeicherten repräsentativen Vorlagen einen Wert umfasst, der ein Lade- und Entladeverhältnis in einer Einheit von einem Tag der Batterie als Wahrscheinlichkeit darstellt.

4. Batteriesystem nach Anspruch 2 oder 3, wobei der Szenario-Generator (331) so konfiguriert ist, dass er basierend auf jedem Zeitpunkt, zu dem ein Ladezustand der repräsentativen Batterie aus den Szenario-Vorlagen von M Tagen umgeschaltet wird, zu jedem Zeitpunkt physikalische Größen aus dem Profil zufällig abtastet, um ein spezifisches Szenario von M Tagen zu erzeugen.

5. Batteriesystem nach einem der Ansprüche 1 bis 4, wobei das Profil Folgendes umfasst:
eine Ladeprotokolltabelle, die aus den Batteriezustandsdaten auf der Grundlage von Daten erzeugt wird, die erhalten werden, wenn sich die Batterie in einem Ladezustand befindet;
eine Entladeprotokolltabelle, die auf der Grundlage von Daten erzeugt wird, die erhalten werden, wenn sich die Batterie in einem Entladezustand befindet; und
eine Ruheprotokolltabelle, die auf der Grundlage von Daten erzeugt wird, die erhalten werden, wenn sich die Batterie in einem Ruhezustand befindet.

6. Batteriesystem nach einem der Ansprüche 2 bis 5, wobei der Szenario-Generator (331) dazu konfiguriert ist,
eine physikalische Größe zu einem Startzeitpunkt einer Ladeperiode der Szenario-Vorlagen von M Tagen aus der Ladeprotokolltabelle abzuleiten;
eine physikalische Größe zu einem Startzeitpunkt einer Entladeperiode der Szenario-Vorlagen von M Tagen aus der Entladeprotokolltabelle abzuleiten; und
eine physikalische Größe zu einem Startzeitpunkt einer Ruheperiode der Szenario-Vorlagen von M Tagen aus der Ruheprotokolltabelle abzuleiten.

7. Batteriesystem nach einem der Ansprüche 2 bis 6, wobei der Szenario-Korrektor (332) dazu konfiguriert ist, eine Anzahl N der Szenarien von M Tagen wiederherzustellen, um die N Szenarien von M Tagen unter Verwendung einer Monte-Carlo-Simulationsmethode zu erzeugen.

8. Batteriesystem nach einem der Ansprüche 2 bis 7, wobei der Lebensdauer-Schätzer (333) dazu konfiguriert ist,
die N Szenarien von M Tagen mehrfach zu simulieren;
eines der Simulationsergebnisse der mehreren Simulationen als Lebensdauer-Schätzmodell für die Batterie zu bestimmen; und
die Lebensdauer der Batterie unter Verwendung des Lebensdauer-Schätzmodells zu schätzen.

9. Lebensdauerschätzverfahren, umfassend:
Erfassen einer Spannung, eines Stroms und einer Temperatur aus einer Batterie;
Schätzen eines Ladezustands (SOC) auf der Grundlage der Spannung, des Stroms und der Temperatur, die aus der Batterie erfasst werden;
**dadurch gekennzeichnet, dass** das Verfahren ferner die folgenden Schritte umfasst:
Erzeugen und Speichern eines Profils durch Messen eines physikalischen Zustands der Batterie in einem Ereigniszählformat auf der Grundlage von Batteriezustandsdaten, die die Spannung, den Strom, die Temperatur und den SOC enthalten;
Erzeugen eines virtuellen Szenarios zum Betreiben einer repräsentativen Batterie auf der Grundlage des Profils; und
Schätzen einer Lebensdauer der Batterie durch das virtuelle Szenario.

10. Lebensdauerschätzverfahren nach Anspruch 9, wobei das Schätzen der Lebensdauer der Batterie Folgendes umfasst:
Erzeugen eines Szenarios von M Tagen, wobei M eine natürliche Zahl größer oder gleich 1 ist;
Erzeugen von N Szenarien von M Tagen basierend auf dem Szenario von M Tagen, wobei N eine natürliche Zahl größer oder gleich 2 ist; und
Schätzen der Lebensdauer der Batterie durch Simulieren eines Batteriebetriebs basierend auf den N Szenarien von M Tagen.

11. Lebensdauerschätzverfahren nach Anspruch 10, wobei das Erzeugen des Szenarios von M Tagen das Erzeugen einer Szenario-Vorlage der M Tage auf der Grundlage einer Auftrittswahrscheinlichkeit jeder von mehreren gespeicherten repräsentativen Vorlagen umfasst, und
wobei jede der mehreren gespeicherten repräsentativen Vorlagen einen Wert umfasst, der ein Lade- und Entladeverhältnis in einer Einheit von einem Tag der Batterie als Wahrscheinlichkeit darstellt.

12. Lebensdauerschätzverfahren nach Anspruch 10 oder 11, wobei das Erzeugen des Szenarios von M Tagen Folgendes umfasst: basierend auf jedem Zeitpunkt, zu dem ein Ladezustand der repräsentativen Batterie aus den Szenario-Vorlagen von M Tagen umgeschaltet wird, physikalische Größen zu jedem Zeitpunkt aus dem Profil zufällig abgetastet werden, um ein spezifisches Szenario von M Tagen zu erzeugen.

13. Lebensdauerschätzverfahren nach einem der Ansprüche 9 bis 12, wobei das Erzeugen und Speichern des Profils Folgendes umfasst:
Erzeugen einer Ladeprotokolltabelle aus den Batteriezustandsdaten auf der Grundlage von Daten, die erhalten werden, wenn sich die Batterie in einem Ladezustand befindet;
Erzeugen einer Entladeprotokolltabelle auf der Grundlage von Daten, die erhalten werden, wenn sich die Batterie in einem Entladezustand befindet; und
Erzeugen einer Ruheprotokolltabelle auf der Grundlage von Daten, die erhalten werden, wenn sich die Batterie in einem Ruhezustand befindet.

14. Lebensdauerschätzverfahren nach Anspruch 12 oder 13, wobei das Erzeugen des spezifischen Szenarios von M Tagen Folgendes umfasst:
Ableiten einer physikalischen Größe zu einem Startzeitpunkt einer Ladeperiode der Szenario-Vorlagen von M Tagen aus der Ladeprotokolltabelle;
Ableiten einer physikalischen Größe zu einem Startzeitpunkt einer Entladeperiode der Szenario-Vorlagen von M Tagen aus der Entladeprotokolltabelle; und
Ableiten einer physikalischen Größe zu einem Startzeitpunkt einer Ruheperiode der Szenario-Vorlagen von M Tagen aus der Ruheprotokolltabelle.

15. Lebensdauerschätzverfahren nach einem der Ansprüche 10 bis 14, wobei das Erzeugen der N Szenarien von M Tagen das Wiederherstellen einer Anzahl N der Szenarien von M Tagen, um die N Szenarien von M Tagen unter Verwendung einer Monte-Carlo-Simulationsmethode zu erzeugen, umfasst.

## Revendications

1. Système de batterie comportant :
une batterie ;
un dispositif de détection (20) configuré pour détecter une tension, un courant et une température à partir de la batterie ; et
un système de gestion de batterie (BMS, (30)) configuré pour :
estimer un état de charge (SOC) sur la base de la tension, du courant et de la température détectés à partir du dispositif de détection (20) ;
**caractérisé en ce que** le système de gestion de batterie (BMS, (30)) est en outre configuré pour stocker un profil généré par la mesure d'un état physique de la batterie dans un format de comptage d'événements sur la base de données d'état de batterie incluant la tension, le courant et la température ainsi que le SOC ;
générer un scénario virtuel de commande d'une batterie représentative sur la base du profil ; et
estimer une durée de vie de la batterie dans le cadre du scénario virtuel.

2. Système de batterie selon la revendication 1, dans lequel le BMS (30) comporte :
un générateur de scénario (331) configuré pour générer un scénario de M jours, M étant un nombre naturel supérieur ou égal à 1 ;
un correcteur de scénario (332) configuré pour générer N scénarios de M jours sur la base du scénario de M jours, N étant un nombre naturel supérieur ou égal à 2 ; et
un estimateur de durée de vie (333) configuré pour estimer la durée de vie de la batterie en simulant un fonctionnement de batterie sur la base des N scénarios de M jours.

3. Système de batterie selon la revendication 2, dans lequel :
le générateur de scénario (331) est configuré pour générer un modèle de scénario des M jours sur la base d'une probabilité d'occurrence de chacun d'une pluralité de modèles représentatifs stockés ; et
chacun de la pluralité de modèles représentatifs stockés comporte une valeur représentant un rapport de charge et de décharge dans une unité d'un jour de la batterie en tant que probabilité.

4. Système de batterie selon la revendication 2 ou 3, dans lequel, sur la base de chaque moment auquel un état de charge de la batterie représentative est commuté parmi les modèles de scénario de M jours, le générateur de scénario (331) est configuré pour échantillonner aléatoirement des quantités physiques à chaque moment à partir du profil pour générer un scénario spécifique de M jours.

5. Système de batterie selon l'une quelconque des revendications 1 à 4, dans lequel le profil comporte :
un tableau de journal de charge généré sur la base de données obtenues si la batterie est dans un état de charge parmi les données d'état de batterie ;
un tableau de journal de décharge généré sur la base de données obtenues si la batterie est dans un état de décharge ; et
un tableau de journal de repos généré sur la base de données obtenues si la batterie est dans un état de repos.

6. Système de batterie selon l'une quelconque des revendications 2 à 5, dans lequel le générateur de scénario (331) est configuré pour :
dériver une quantité physique à un moment de début d'une période de charge des modèles de scénario de M jours à partir du tableau de journal de charge ;
dériver une quantité physique à un moment de début d'une période de décharge des modèles de scénario de M jours à partir du tableau de journal de décharge ; et
dériver une quantité physique à un moment de début d'une période de repos des modèles de scénario de M jours à partir du tableau de journal de repos.

7. Système de batterie selon l'une quelconque des revendications 2 à 6, dans lequel le correcteur de scénario (332) est configuré pour restaurer un nombre N des scénarios de M jours pour générer les N scénarios de M jours à l'aide d'un procédé de simulation de Monte-Carlo.

8. Système de batterie selon l'une quelconque des revendications 2 à 7, dans lequel l'estimateur de durée de vie (333) est configuré pour :
simuler les N scénarios de M jours plusieurs fois ;
déterminer l'un des résultats de simulation des multiples simulations en tant que modèle d'estimation de durée de vie pour la batterie ; et
estimer la durée de vie de la batterie à l'aide du modèle d'estimation de durée de vie.

9. Procédé d'estimation de durée de vie comportant :
la détection d'une tension, d'un courant et d'une température à partir d'une batterie ;
l'estimation d'un état de charge (SOC) sur la base de la tension, du courant et de la température détectés à partir de la batterie ;
**caractérisé en ce que** le procédé comporte en outre les étapes de : la génération et le stockage d'un profil en mesurant un état physique de la batterie dans un format de comptage d'événements sur la base de données d'état de batterie incluant la tension, le courant et la température ainsi que le SOC ;
la génération d'un scénario virtuel pour commander une batterie représentative sur la base du profil ; et
l'estimation d'une durée de vie de la batterie dans le cadre du scénario virtuel.

10. Procédé d'estimation de durée de vie selon la revendication 9, dans lequel l'estimation de la durée de vie de la batterie comporte :
la génération d'un scénario de M jours, M étant un nombre naturel supérieur ou égal à 1 ;
générer N scénarios de M jours sur la base du scénario de M jours, N étant un nombre naturel supérieur ou égal à 2 ; et
l'estimation de la durée de vie de la batterie en simulant un fonctionnement de batterie sur la base des N scénarios de M jours.

11. Procédé d'estimation de durée de vie selon la revendication 10, dans lequel la génération du scénario de M jours comporte la génération d'un modèle de scénario des M jours sur la base d'une probabilité d'occurrence de chacun d'une pluralité de modèles représentatifs stockés, et
dans lequel chacun de la pluralité de modèles représentatifs stockés comporte une valeur représentant un rapport de charge et de décharge dans une unité d'un jour de la batterie en tant que probabilité.

12. Procédé d'estimation de durée de vie selon la revendication 10 ou 11, dans lequel la génération du scénario de M jours comporte, sur la base de chaque moment auquel un état de charge de la batterie représentative est commuté parmi les modèles de scénario de M jours, l'échantillonnage aléatoire de quantités physiques à chaque moment à partir du profil pour générer un scénario spécifique de M jours.

13. Procédé d'estimation de durée de vie selon l'une quelconque des revendications 9 à 12, dans lequel la génération et le stockage du profil comportent :
la génération d'un tableau de journal de charge sur la base de données obtenues si la batterie est dans un état de charge parmi les données d'état de batterie ;
la génération d'un tableau de journal de décharge sur la base de données obtenues si la batterie est dans un état de décharge ; et
la génération d'un tableau de journal de repos sur la base de données obtenues si la batterie est dans un état de repos.

14. Procédé d'estimation de durée de vie selon la revendication 12 ou 13, dans lequel la génération du scénario spécifique de M jours comporte :
la dérivation d'une quantité physique à un moment de début d'une période de charge des modèles de scénario de M jours à partir du tableau de journal de charge ;
la dérivation d'une quantité physique à un moment de début d'une période de décharge des modèles de scénario de M jours à partir du tableau de journal de décharge ; et
la dérivation d'une quantité physique à un moment de début d'une période de repos des modèles de scénario de M jours à partir de la table de journal de repos.

15. Procédé d'estimation de durée de vie selon l'une quelconque des revendications 10 à 14, dans lequel la génération des N scénarios de M jours comporte la restauration d'un nombre N des scénarios de M jours pour générer les N scénarios de M jours à l'aide d'un procédé de simulation de Monte-Carlo.
